# EUROPEAN PATENT SPECIFICATION

(11) **EP 3 029 739 B1**
(45) Date of publication and mention of the grant of the patent: **24.06.2020**
(21) Application number: 15003388.4
(22) Date of filing: 27.11.2015
(51) Int. Cl.: H01L 31/0352, H01L 31/0368, H01L 31/0224, H01L 31/0216, H01L 31/0747

(54) **SOLAR CELL AND METHOD FOR MANUFACTURING THE SAME**
SOLARZELLE UND VERFAHREN ZUR HERSTELLUNG DAVON
CELLULE SOLAIRE ET SON PROCÉDÉ DE FABRICATION

(30) Priority: 28.11.2014 KR 20140168612
(43) Date of publication of application: 08.06.2016
(73) Proprietor: LG Electronics Inc., Seoul 07336 (KR)
(72) Inventor: Chung, Jinwon, 08592 Seoul (KR); Lee, Yujin, 08592 Seoul (KR); Ji, Kwangsun, 08592 Seoul (KR)
(74) Representative: Katérle, Axel

(56) References cited:
- EP-A1- 2 797 124
- EP-A2- 2 293 351
- EP-A2- 2 575 184
- US-A1- 2009 293 948

## Description

### BACKGROUND OF THE INVENTION

### Field of the Invention

The present disclosure relates to a solar cell and a method for manufacturing the same.

### Description of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted.

A solar cell generally includes semiconductor parts, which respectively have different conductive types, for example, a p-type and an n-type and thus form a p-n junction, and electrodes respectively connected to the semiconductor parts of the different conductive types.

When light is incident on the solar cell, a plurality of electron-hole pairs are produced in the semiconductor parts and are separated into electrons and holes. The electrons move to the n-type semiconductor part, and the holes move to the p-type semiconductor part. Then, the electrons and the holes are collected by the different electrodes respectively connected to the n-type semiconductor part and the p-type semiconductor part. The electrodes are connected to each other using electric wires to thereby obtain electric power.

EP 2 293 351 A2 discloses a method in which a front surface field region is formed of an amorphous silicon layer or a polycrystalline silicon by using a PECVD method.

EP 2 575 184 A2 discloses a solar cell including a front surface field region formed of amorphous silicon oxide or amorphous silicon carbide.

### SUMMARY OF THE INVENTION

In one aspect, there is a solar cell including a semiconductor substrate containing impurities of a first conductive type; a front surface field region positioned at a front surface of the semiconductor substrate; a front tunnel layer positioned between the front surface field region and the semiconductor substrate; an anti-reflection layer positioned on a front surface of the front surface field region, the front surface field region containing impurities of the first conductive type at a higher concentration than that of the semiconductor substrate, the front surface field region having a crystal structure or a crystallinity different from that of the semiconductor substrate, wherein the crystallinity of the front surface field region increases from the front tunnel layer to the anti-reflection layer; an emitter region positioned at a back surface of the semiconductor substrate, the emitter region having a second conductive type opposite the first conductive type; a back surface field region positioned at the back surface of the semiconductor substrate, the back surface field region containing impurities of the first conductive type at a higher concentration than that of the semiconductor substrate; a first electrode connected to the emitter region; and a second electrode connected to the back surface field region, as further defined in the claims.

The front surface field region may contain at least one of nitrogen (N), carbon (C), and oxygen (O) and may include a polycrystalline silicon material. The back surface field region may partially include amorphous silicon.

The crystallinity of the front surface field region may be between 60 % and 100 %, and a thickness of the front surface field region may be 5 nm to 20 nm.

The solar cell comprises a front tunnel layer positioned between the front surface field region and the semiconductor substrate, the front tunnel layer including a dielectric material. The dielectric material of the front tunnel layer may include at least one of silicon carbide (SiCx) and silicon oxide (SiOx).

A thickness of the front surface field region may be greater than a thickness of the front tunnel layer. For example, a thickness of the front tunnel layer may be 0.5 nm to 5 nm.

The solar cell comprises an anti-reflection layer positioned on a front surface of the front surface field region, the anti-reflection layer including a dielectric material.

At least one of the emitter region and the back surface field region may have a crystal structure different from that of the semiconductor substrate.

The solar cell may further comprise a back tunnel layer positioned between the back surface of the semiconductor substrate and a front surface of the emitter region, between the back surface of the semiconductor substrate and a front surface of the back surface field region, or both, the back tunnel layer including a dielectric material.

In another aspect, there is a method for manufacturing a solar cell including a doped amorphous silicon layer depositing operation of depositing a doped amorphous silicon layer on a front surface of a semiconductor substrate while injecting impurities of a first conductive type into a chamber; a back semiconductor layer forming operation of forming an emitter semiconductor layer of a second conductive type opposite the first conductive type and a back surface field semiconductor layer, which contains impurities of the first conductive type at a higher concentration than that of the semiconductor substrate, on a back surface of the semiconductor substrate; and a thermal processing operation of thermally processing the semiconductor substrate and recrystallizing the doped amorphous silicon layer to form a front surface field region.

In the doped amorphous silicon layer depositing operation, at least one of nitrogen (N), carbon (C), and oxygen (O) may be injected into the chamber.

The method may further comprise a diffusion barrier layer forming operation of forming a diffusion barrier layer including a dielectric material on a front surface of the doped amorphous silicon layer between the doped amorphous silicon layer depositing operation and the thermal processing operation; and an operation of removing the diffusion barrier layer after the thermal processing operation.

The thermal processing operation may include activating impurities of the first and second conductive types while forming the front surface field region to form an emitter region and a back surface field region using the emitter semiconductor layer and the back surface field semiconductor layer, respectively.

The thermal processing operation includes recrystallizing at least a portion of the doped amorphous silicon layer into a polycrystalline silicon material to perform a phase change. In the thermal processing operation, the doped amorphous silicon layer may be crystallized at a crystallinity of 60 % to 100 %.

The thermal processing operation may be performed at a temperature of 800 °C to 925 °C.

The method comprises, before the doped amorphous silicon layer depositing operation, forming a front tunnel layer including a dielectric material on the front surface of the semiconductor substrate. In the doped amorphous silicon layer depositing operation, the doped amorphous silicon layer may be deposited on a front surface of the front tunnel layer.

The method may further comprise, before the back semiconductor layer forming operation, forming a back tunnel layer including a dielectric material on the back surface of the semiconductor substrate. The emitter semiconductor layer and the back surface field semiconductor layer may be deposited on a back surface of the back tunnel layer.

In the doped amorphous silicon layer depositing operation, the doped amorphous silicon layer may be deposited through a plasma enhanced chemical vapor deposition (PECVD) method.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIGS. 1 to 3 illustrate a solar cell according to an example embodiment of the invention;
FIG. 4 illustrates a light absorptance of a front surface field region shown in FIGS. 1 to 3;
FIG. 5 illustrates an external quantum efficiency of a front surface field region according to an example embodiment of the invention; and
FIG. 6 is a flow chart showing a method for manufacturing a solar cell according to an example embodiment of the invention.

### DETAILED DESCRIPTION OF THE EMBODIMENTS

Reference will now be made in detail to embodiments of the invention, examples of which are illustrated in the accompanying drawings. This invention may, however, be embodied in many different forms and should not be construed as limited to the embodiments set forth herein. Wherever possible, the same reference numbers will be used throughout the drawings to refer to the same or like parts. It will be noted that a detailed description of known arts will be omitted if it is determined that the detailed description of the known arts can obscure the embodiments of the invention.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on other element, it may be on the entire surface of the other element and may not be on a portion of an edge of the other element.

In the following description, "front surface" may be one surface of a semiconductor substrate, on which light is directly incident, and "back surface" may be a surface opposite the one surface of the semiconductor substrate, on which light is not directly incident or reflective light may be incident.

The fact that any two values are equal to each other means that the two values are equal to each other within a margin of error of 10 % or less.

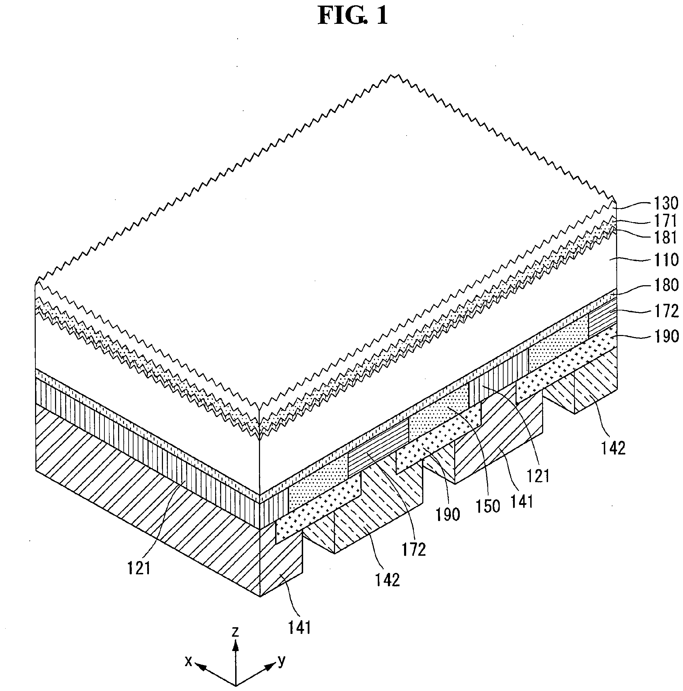

FIGS. 1 to 3 illustrate a solar cell according to an example embodiment of the invention.

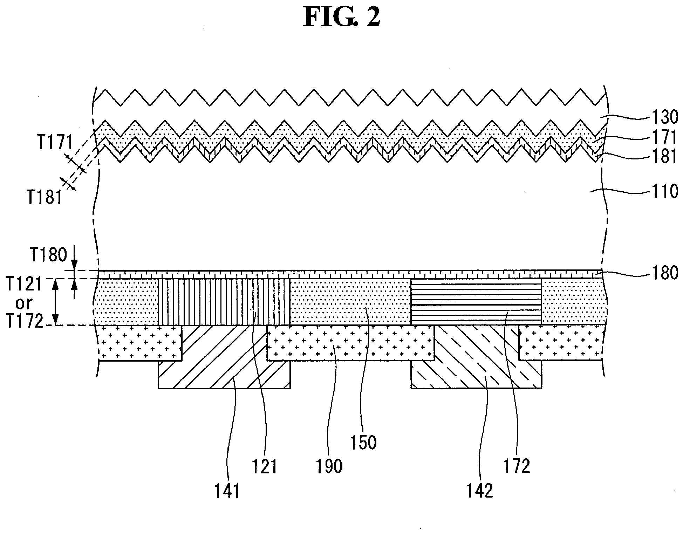

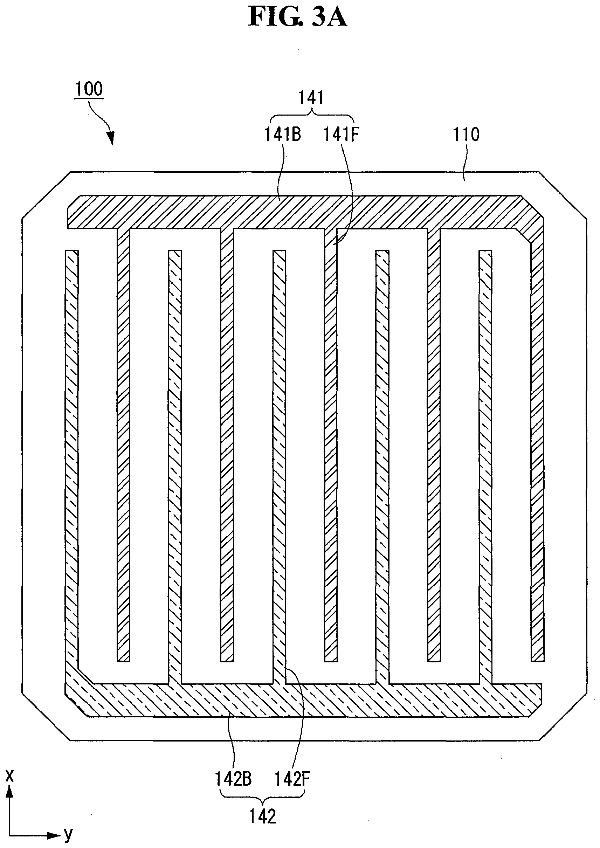

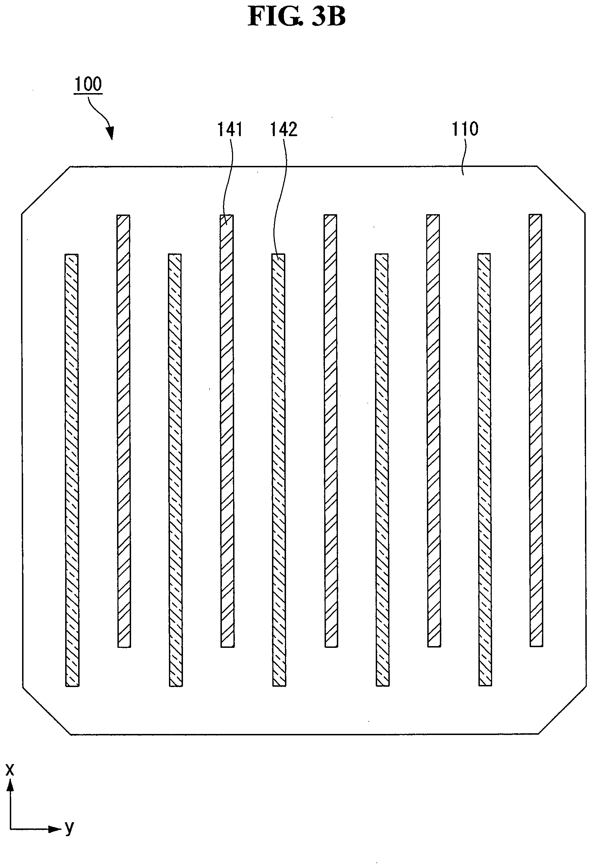

More specifically, FIG. 1 is a partial perspective view of the solar cell according to the embodiment of the invention, and FIG. 2 is a partial cross-sectional view taken along a second direction of the solar cell shown in FIG. 1. FIGS. 3A and 3B show patterns of first and second electrodes positioned on a back surface of the solar cell according to the embodiment of the invention.

As shown in FIGS. 1 and 2, a solar cell according to the embodiment of the invention includes an anti-reflection layer 130, a front surface field region 171, a front tunnel layer 181, a semiconductor substrate 110, may include a back tunnel layer 180, a plurality of emitter regions 121, a plurality of back surface field regions 172, an intrinsic semiconductor layer 150, a back passivation layer 190, and includes a first electrode 141, and a second electrode 142.

In the embodiment disclosed herein, the intrinsic semiconductor layer 150, the back tunnel layer 180, and the passivation layer 190 may be omitted, if desired or necessary. However, when the solar cell includes the the intrinsic semiconductor layer 150, the back tunnel layer 180, and the passivation layer 190, efficiency of the solar cell may be further improved. Thus, the embodiment of the invention is described using the solar cell including the intrinsic semiconductor layer 150, the back tunnel layer 180, and the passivation layer 190, as an example.

The semiconductor substrate 110 may be formed of at least one of single crystal silicon and polycrystalline silicon containing impurities of a first conductive type. For example, the semiconductor substrate 110 may be formed of a single crystal silicon wafer.

In the embodiment disclosed herein, the first conductive type may be one of an n-type and a p-type.

When the semiconductor substrate 110 is of the p-type, the semiconductor substrate 110 may be doped with impurities of a group III element, such as boron (B), gallium (Ga), and indium (In). Alternatively, when the semiconductor substrate 110 is of the n-type, the semiconductor substrate 110 may be doped with impurities of a group V element, such as phosphorus (P), arsenic (As), and antimony (Sb).

In the following description, the embodiment of the invention is described using an example where the first conductive type is the n-type.

A front surface of the semiconductor substrate 110 may be an uneven surface having a plurality of uneven portions or having uneven characteristics. Thus, the anti-reflection layer 130, the front surface field region 171, the front tunnel layer 181 positioned on the front surface of the semiconductor substrate 110 may have an uneven surface.

Hence, an amount of light reflected from the front surface of the semiconductor substrate 110 may decrease, and an amount of light incident on the inside of the semiconductor substrate 110 may increase.

The front surface field region 171 is positioned at the front surface of the semiconductor substrate 110 and may include a polycrystalline silicon material containing impurities of the first conductive type at a higher concentration than the semiconductor substrate 110. Thus, if the semiconductor substrate 110 is of the n-type, for example, the front surface field region 171 may be an n⁺-type region.

The front surface field region 171 has a crystal structure and/or a crystallinity different from the semiconductor substrate 110. For example, the semiconductor substrate 110 may be formed of at least one of single crystal silicon or polycrystalline silicon, and the front surface field region 171 may be formed of at least one of microcrystal silicon, polycrystalline silicon or polycrystalline silicon material, and is obtained by recrystallizing amorphous silicon different from that of the semiconductor substrate 110.

The front surface field region 171 is formed by depositing an intrinsic amorphous silicon layer on the front surface of the semiconductor substrate 110, doping impurities of the first conductive type on the intrinsic amorphous silicon layer, and then crystallizing at least a portion of the doped amorphous silicon layer in a thermal processing operation.

The doped amorphous silicon layer may be thermally processed along with the emitter region 121 and the back surface field region 172 in the thermal processing operation forming the emitter region 121 and the back surface field region 172, and thus may be crystallized into the polycrystalline silicon material.

The front surface field region 171 may contain at least one of nitrogen (N), carbon (C), and oxygen (O), so as to minimize a light absorptance of the front surface field region 171.

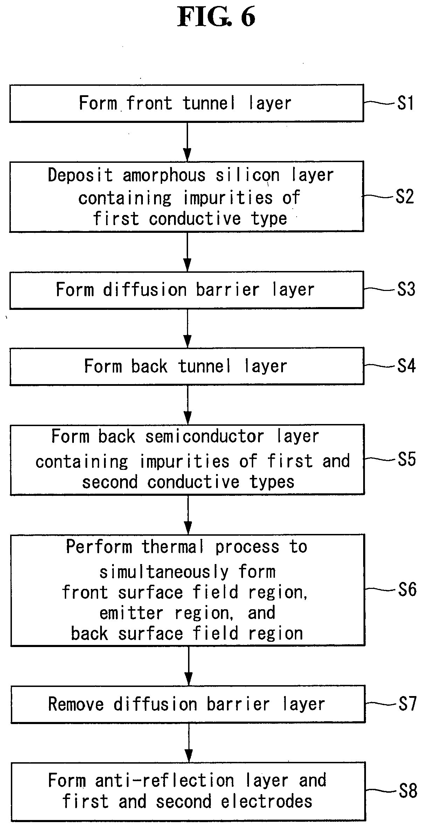

A method for forming the front surface field region 171 is described in detail later with reference to FIG. 6.

A potential barrier is formed by a difference between impurity concentrations of the semiconductor substrate 110 and the front surface field region 171. Hence, the front surface field region 171 may have a field effect, which prevents carriers (for example, holes) from moving to the front surface of the semiconductor substrate 110 through the potential barrier.

Thus, the front surface field region 171 can increase an amount of carriers output to an external device and reduce an amount of carriers lost by a recombination and/or a disappearance of electrons and holes at and around the front surface of the semiconductor substrate 110.

A thickness of the front surface field region 171 may be greater than a thickness of the front tunnel layer 181, so as to sufficiently secure the above-described field effect.

The front tunnel layer 181 is positioned between the front surface field region 171 and the semiconductor substrate 110 and may include a dielectric material. For example, the front tunnel layer 181 may be formed of at least one of silicon carbide (SiCx) and silicon oxide (SiOx).

The front tunnel layer 181 may perform a passivation function at the surface of the semiconductor substrate 110. When an excessive amount of carriers exists in the semiconductor substrate 110 and a portion of carriers existing in the semiconductor substrate 110 moves to the front surface field region 171, the front tunnel layer 181 may perform a tunneling function, which makes it easier for the carriers to move to the front surface field region 171.

The front tunnel layer 181 may prevent impurities of the first conductive type contained in the front surface field region 171 or at least one of nitrogen (N), carbon (C), and oxygen (O) contained in the front surface field region 171 for a reduction in the light absorptance of the front surface field region 171 from being diffused into the semiconductor substrate 110 when the front surface field region 171 is formed.

Thus, the front surface field region 171 may be configured as a layer formed of one of n⁺-mc-SiNx, n⁺-mc-SiCx, and n⁺-mc-SiOx, whereby "mc" denotes microcrystalline, for example.

A thickness T181 of the front tunnel layer 181 may be 0.5 nm to 5 nm.

When the thickness T181 of the front tunnel layer 181 is equal to or greater than 0.5 nm, the passivation function of the front tunnel layer 181 may be secured to a minimum. When the thickness T181 of the front tunnel layer 181 is equal to or less than 5 nm, the tunneling function of the front tunnel layer 181 may be secured while further increasing the passivation function. The optimum thickness T181 of the front tunnel layer 181 may be determined between 0.5 nm and 1.6 nm, for example. The front tunnel layer 181 may optimally show the passivation function and the tunneling function within the above thickness range.

The thickness T181 of the front tunnel layer 181 may be equal to or greater than a thickness T180 of the back tunnel layer 180 within the above thickness range. The thickness T180 of the back tunnel layer 180 will be described later. When the thickness T181 of the front tunnel layer 181 is greater than the thickness T180 of the back tunnel layer 180, a tunneling effect of the front tunnel layer 181 may be slightly reduced, but the passivation function of the front tunnel layer 181 may further increase.

In this instance, because the electrodes are not positioned on the front surface of the semiconductor substrate 110, an effect obtained by an increase in the passivation function is more advantageous to the solar cell than a reduction in the tunneling effect. Hence, the efficiency of the solar cell may be improved.

The anti-reflection layer 130 is positioned on a front surface of the front surface field region 171 and may be formed of a dielectric material, thereby minimizing the reflection of light incident on the front surface of the semiconductor substrate 110 from the outside. The dielectric material of the anti-reflection layer 130 may be at least one of aluminum oxide (AlOx), silicon nitride (SiNx), silicon oxide (SiOx), and silicon oxynitride (SiOxNy). As shown in FIGS. 1 and 2, the anti-reflection layer 130 may have a single layer. Alternatively, the anti-reflection layer 130 may have a plurality of layers.

Silicon nitride (SiNx) or silicon oxide (SiOx) used in the anti-reflection layer 130 is different from n⁺-mc-SiNx or n⁺-mc-SiOx applied to the front surface field region 171.

A comparison between silicon nitride (SiNx) or silicon oxide (SiOx) of the anti-reflection layer 130 and n⁺-mc-SiNx or n⁺-mc-SiOx of the front surface field region 171 is described below.

Impurities of the first conductive type are not included in SiNx or SiOx used in the anti-reflection layer 130, and silicon (Si) material of in SiNx or SiOx used in the anti-reflection layer 130 is not crystalline. Further, a chemical bonding state of SiNx or SiOx of the anti-reflection layer 130 may be different from a bonding state of n⁺-mc-SiNx or n⁺-mc-SiOx of the front surface field region 171.

More specifically, in the anti-reflection layer 130, SiNx or SiOx particle is randomly disposed in a state where Si does not form a crystal. However, n⁺-mc-SiNx or n⁺-mc-SiOx of the front surface field region 171 may have a structure such that SiNx or SiOx particle is positioned in an empty space between the Si crystals or in the Si crystals in a state where Si forms a crystal.

The back tunnel layer 180 is positioned on an entire back surface of the semiconductor substrate 110 while directly contacting it and may include a dielectric material. Thus, as shown in FIGS. 1 and 2, the back tunnel layer 180 may directly contact the back surface of the semiconductor substrate 110 formed of single crystal silicon.

The back tunnel layer 180 may pass through carriers produced in the semiconductor substrate 110 and may perform a passivation function at the back surface of the semiconductor substrate 110.

The back tunnel layer 180 may be formed of a dielectric material including silicon carbide (SiCx) or silicon oxide (SiOx) having strong durability at a high temperature equal to or higher than 600 °C. In addition, the back tunnel layer 180 may be formed of silicon nitride (SiNx), hydrogenated SiNx, aluminum oxide (AlOx), silicon oxynitride (SiON), or hydrogenated SiON. The thickness T180 of the back tunnel layer 180 may be 0.5 nm to 2.5 nm.

The plurality of emitter regions 121 directly contact a portion of a back surface of the back tunnel layer 180. The plurality of emitter regions 121 extend in a first direction x. The emitter regions 120 may be formed of polycrystalline silicon material of a second conductive type opposite the first conductive type. The emitter region 120 may form a p-n junction along with the semiconductor substrate 110 with the back tunnel layer 180 interposed therebetween.

Because each emitter region 121 forms the p-n junction along with the semiconductor substrate 110, the emitter region 121 may be of the p-type. However, if the semiconductor substrate 110 is of the p-type unlike the embodiment described above, the emitter region 121 may be of the n-type. In this instance, separated electrons may move to the plurality of emitter regions 121, and separated holes may move to the plurality of back surface field regions 172.

Returning to the embodiment of the invention, when the emitter regions 121 are of the p-type, the emitter regions 121 may be doped with impurities of a group III element such as B, Ga, and In. On the contrary, if the emitter regions 121 are of the n-type, the emitter regions 121 may be doped with impurities of a group V element such as P, As, and Sb.

The emitter regions 121 may be formed by depositing an intrinsic polycrystalline silicon layer on the back surface of the back tunnel layer 180 and then injecting impurities of the second conductive type into the intrinsic polycrystalline silicon layer. Alternatively, the emitter regions 121 may be formed by depositing an intrinsic amorphous silicon layer on the back surface of the back tunnel layer 180, recrystallizing the intrinsic amorphous silicon layer into an intrinsic polycrystalline silicon layer through a thermal processing, and injecting impurities of the second conductive type into the recrystallized intrinsic polycrystalline silicon layer.

The plurality of back surface field regions 172 may be positioned at the back surface of the back tunnel layer 180, on which the plurality of emitter regions 121 are not positioned, and may directly contact the back surface of the back tunnel layer 180. The plurality of back surface field regions 172 may extend in the same first direction x as the plurality of emitter regions 121.

The back surface field regions 172 may be formed of polycrystalline silicon material doped with impurities of the first conductive type at a higher concentration than the semiconductor substrate 110. Thus, when the semiconductor substrate 110 is doped with, for example, n-type impurities, the plurality of back surface field regions 172 may be an n⁺-type region.

A potential barrier is formed by a difference between impurity concentrations of the semiconductor substrate 110 and the back surface field regions 172. Hence, the back surface field regions 172 can prevent or reduce holes from moving to the back surface field regions 172 used as a moving path of electrons through the potential barrier and can make it easier for carriers (for example, electrons) to move to the back surface field regions 172.

Thus, the back surface field regions 172 can reduce an amount of carriers lost by a recombination and/or a disappearance of electrons and holes at and around the back surface field regions 172 or at and around the first and second electrodes 141 and 142 and can accelerates a movement of electrons, thereby increasing an amount of electrons moving to the back surface field regions 172.

The back surface field regions 172 may be formed using the same method as the emitter regions 121. Namely, the back surface field regions 172 may be formed by depositing an intrinsic polycrystalline silicon layer on the back surface of the back tunnel layer 180 and then injecting impurities of the second conductive type into the intrinsic polycrystalline silicon layer. Alternatively, the back surface field regions 172 may be formed by depositing an intrinsic amorphous silicon layer on the back surface of the back tunnel layer 180, recrystallizing the intrinsic amorphous silicon layer into an intrinsic polycrystalline silicon layer through a thermal processing, and injecting impurities of the second conductive type into the recrystallized intrinsic polycrystalline silicon layer.

Because the back surface field region 172 may be formed by recrystallizing the intrinsic amorphous silicon layer into the intrinsic polycrystalline silicon layer, the back surface field region 172 may partially include the amorphous silicon material.

Thus, at least one of the emitter region 121 and the back surface field region 172 may have a crystal structure different from the semiconductor substrate 110.

Thicknesses T121 and T172 of the emitter region 121 and the back surface field region 172 may be 100 nm to 300 nm. FIGS. 1 and 2 show that the thicknesses T121 and T172 of the emitter region 121 and the back surface field region 172 are equal to each other, as an example. Alternatively, the thicknesses T121 and T172 of the emitter region 121 and the back surface field region 172 may be different from each other.

The intrinsic semiconductor layer 150 may be formed in a space between the emitter region 121 and the back surface field region 172 on the back surface of the back tunnel layer 180 while directly contacting the back surface of the back tunnel layer 180. The intrinsic semiconductor layer 150 may be formed of intrinsic polycrystalline silicon, which is not doped with impurities of the first conductive type and impurities of the second conductive type, unlike the emitter region 121 and the back surface field region 172.

Thus, the intrinsic semiconductor layer 150 may be formed using the same method as the emitter region 121 and the back surface field region 172, except that impurities of the first conductive type and impurities of the second conductive type are doped. The intrinsic semiconductor layer 150 may be formed at the same time as the emitter region 121 and the back surface field region 172.

As described above, the intrinsic semiconductor layer 150 may be formed in the space between the emitter region 121 and the back surface field region 172 on the back surface of the back tunnel layer 180. In this instance, as shown in FIGS. 1 and 2, both sides of the intrinsic semiconductor layer 150 may directly contact the side of the emitter region 121 and the side of the back surface field region 172, respectively.

The passivation layer 190 removes a defect resulting from a dangling bond formed in a back surface of the intrinsic polycrystalline silicon layer formed at the back surface field region 172, the intrinsic semiconductor layer 150, and the emitter region 121, and thus can prevent carriers produced in the semiconductor substrate 110 from being recombined and disappeared by the dangling bond.

For this, the passivation layer 190 may fully cover the back surface of the intrinsic semiconductor layer 150, cover a remaining portion excluding a portion connected to the first electrode 141 from a back surface of the emitter region 121, and cover a remaining portion excluding a portion connected to the second electrode 142 from a back surface of the back surface field region 172.

The passivation layer 190 may be formed of a dielectric material. For example, the passivation layer 190 may include a single layer or a plurality of layers formed of at least one of hydrogenated silicon nitride (SiNx:H), hydrogenated silicon oxide (SiOx:H), hydrogenated silicon nitride oxide (SiNxOy:H), hydrogenated silicon oxynitride (SiOxNy:H), and hydrogenated amorphous silicon (a-Si:H).

FIGS. 1 and 2 show that the sides of the emitter region 121 and the back surface field region 172 formed at the back surface of the back tunnel layer 180 are separated from each other, and the intrinsic semiconductor layer 150 is positioned in the space between the emitter region 121 and the back surface field region 172 on the back surface of the back tunnel layer 180, as an example. Alternatively, the back tunnel layer 180 may be omitted, or the emitter region 121 and the back surface field region 172 may contact each other.

The first electrode 141 may be connected to each emitter region 121 and may collect carriers (for example, holes) moving to the corresponding emitter region 121.

The second electrode 142 may be connected to each back surface field region 172 and may collect carriers (for example, electrons) moving to the corresponding back surface field region 172.

A pattern of the first and second electrodes 141 and 142 is described in detail below with reference to FIG. 3.

As shown in FIGS. 3A and 3B, in the solar cell according to the embodiment of the invention, the first electrode 141 may include a plurality of first finger electrodes 141F and a first bus bar 141B, and the second electrode 142 may include a plurality of second finger electrodes 142F and a second bus bar 142B.

The plurality of first finger electrodes 141F may extend in the first direction x. The first bus bar 141B may extend in a second direction y crossing a longitudinal direction, i.e., the first direction x of the first finger electrodes 141F and may be commonly connected to ends of the plurality of first finger electrodes 141F.

Further, the plurality of second finger electrodes 142F may extend in the first direction x. The second bus bar 142B may extend in the second direction y crossing a longitudinal direction, i.e., the first direction x of the second finger electrodes 142F and may be commonly connected to ends of the plurality of second finger electrodes 142F.

FIG. 3A shows that the first electrode 141 includes the plurality of first finger electrodes 141F and the first bus bar 141B, and the second electrode 142 includes the plurality of second finger electrodes 142F and the second bus bar 142B, as an example. Alternatively, the first and second bus bars 141B and 142B may be omitted in the first electrode 141 and the second electrode 142 shown in FIG. 3A.

Thus, as shown in FIG. 3B, the first and second electrodes 141 and 142 may respectively include only the first and second finger electrodes extending in the first direction x.

FIG. 3B shows that a location of both ends of the first electrode 141 extending in the first direction x is different from a location of both ends of the second electrode 142 extending in the first direction x, as an example. Alternatively, the locations of both ends of the first and second electrodes 141 and 142 may be positioned on the same line of the second direction y.

As described above, in the solar cell 100 according to the embodiment of the invention, the front surface field region 171 may be formed of polycrystalline silicon material containing at least one of nitrogen (N), carbon (C), and oxygen (O), so as to minimize the light absorptance of the front surface field region 171.

FIGS. 1 and 2 show that the front surface field region 171 includes a single layer, as an example. Alternatively, the front surface field region 171 may include a plurality of layers each including a different element among nitrogen (N), carbon (C), and oxygen (O).

As described above, the front surface field region 171 according to the embodiment of the invention includes the polycrystalline silicon material. Therefore, a light absorptance of the front surface field region 171 formed of the polycrystalline silicon material may be less than a light absorptance of the front surface field region 171 formed of an amorphous silicon material.

More specifically, a band gap energy of the amorphous silicon material is 1.7 eV and is higher than a band gap energy, 1.1 eV, of the polycrystalline silicon material. However, a light absorptance of the polycrystalline silicon material is less than a light absorptance of the amorphous silicon material because of the properties of the material.

In other words, although the band gap energy of the amorphous silicon material is 1.7 eV and is higher than the band gap energy of the polycrystalline silicon material, the light absorptance of the amorphous silicon material may be about 100 times greater than the light absorptance of the polycrystalline silicon material at a wavelength band of 300 nm to 800 nm, for example, because the amorphous silicon material has a direct band gap because of the properties of the material, and the polycrystalline silicon material has an indirect band gap because of the properties of the material.

Thus, when the front surface field region 171 according to the embodiment of the invention includes the polycrystalline silicon material, the light absorptance of the front surface field region 171 may be further reduced. Hence, the efficiency of the solar cell may be further improved.

When the front surface field region 171 including the polycrystalline silicon material contains at least one of nitrogen (N), carbon (C), and oxygen (O) as described above, nitrogen (N), carbon (C), and oxygen (O) may increase the band gap energy of the polycrystalline silicon material because of the properties of the element.

Thus, when the front surface field region 171 contains at least one of nitrogen (N), carbon (C), and oxygen (O), the light absorptance of the front surface field region 171 may be further reduced. Hence, the efficiency of the solar cell may be further improved.

Crystallinity of the front surface field region 171 may be determined between 60 % and 100 %. The crystallinity of the front surface field region 171 increases as the front surface field region 171 goes from the front tunnel layer 181 to the anti-reflection layer 130. In the embodiment disclosed herein, the crystallinity of the front surface field region 171 indicates a percentage of a crystallized portion based on the total volume of the front surface field region 171.

Thus, the front surface field region 171 may include a crystallized portion and an uncrystallized portion of the doped amorphous silicon material. The crystallized portion of the front surface field region 171 may remain in the polycrystalline silicon material, and the uncrystallized portion of the front surface field region 171 may remain in the amorphous silicon material.

For example, in a vertical cross section of the front surface field region 171, a portion of the front surface field region 171 positioned at the anti-reflection layer 130 may exist in a crystalline state, and a portion of the front surface field region 171 positioned at the front tunnel layer 181 may exist in an amorphous state.

Thus, the uncrystallized portion of the front surface field region 171 may include the amorphous silicon material containing at least one of nitrogen (N), carbon (C), and oxygen (O).

When the crystallinity of the front surface field region 171 is equal to or greater than 60 %, a minimum light transmittance of the front surface field region 171 may be secured. Namely, when the crystallinity of the front surface field region 171 is equal to or greater than 60 %, a minimum portion of the polycrystalline silicon material may be secured and may reduce the light absorptance of the front surface field region 171 at a good level.

Thus, as the crystallinity of the front surface field region 171 is close to 100 %, the light absorptance of the front surface field region 171 may be further reduced and minimized.

A thickness T171 of the front surface field region 171 may be 5 nm to 20 nm.

When the thickness T171 of the front surface field region 171 is equal to or greater than 5 nm, a minimum electric field effect of the front surface field region 171 may be secured. Setting the thickness T171 of the front surface field region 171 to be equal to or less than 20 is determined in consideration of the light absorptance of the front surface field region 171. As the thickness T171 of the front surface field region 171 increases, the light absorptance of the front surface field region 171 may increase. Thus, the thickness T171 of the front surface field region 171 may be set, so that the front surface field region 171 has the minimum light absorptance.

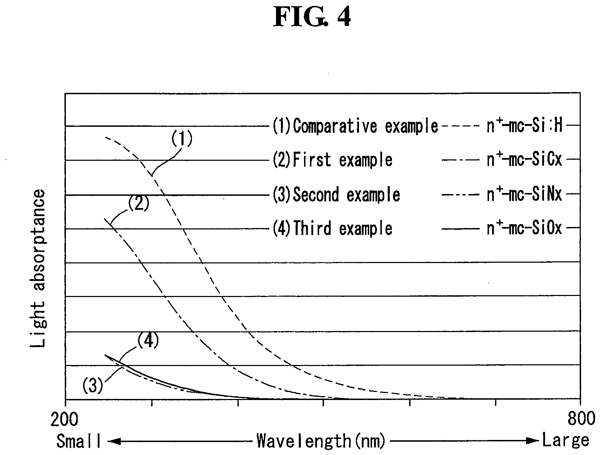

FIG. 4 illustrates the light absorptance of the front surface field region shown in FIGS. 1 to 3.

More specifically, FIG. 4 is a graph showing a light absorptance of the front surface field region 171 depending on a wavelength when the front surface field region 171 includes the polycrystalline silicon material containing one of nitrogen (N), carbon (C), and oxygen (O).

In FIG. 4, (1) is a comparative example showing a light absorptance of the front surface field region 171 when the front surface field region 171 is formed of n⁺-mc-Si:H containing hydrogen (H); (2) is a first example showing a light absorptance of the front surface field region 171 when the front surface field region 171 is formed of n⁺-mc-SiCx containing carbon (C); (3) is a second example showing a light absorptance of the front surface field region 171 when the front surface field region 171 is formed of n⁺-mc-SiNx containing nitrogen (N); and (4) is a third example showing a light absorptance of the front surface field region 171 when the front surface field region 171 is formed of n⁺-mc-SiOx containing oxygen (O).

As shown in FIG. 4, there was little difference between the light absorptances of the examples (1) to (4) at a high wavelength, for example, at a wavelength equal to or greater than 600 nm. On the other hand, as the wavelength moved from 600 nm to 200 nm (i.e., to a short wavelength band), the light absorptance of the comparative example (1) greatly increased, compared to the light absorptances of the first to third examples (2) to (4).

Because the front surface field region 171 according to the embodiment of the invention includes the polycrystalline silicon material containing at least one of nitrogen (N), carbon (C), and oxygen (O) as described above, the light absorptance of the front surface field region 171 may be minimized. Hence, the efficiency of the solar cell may be improved.

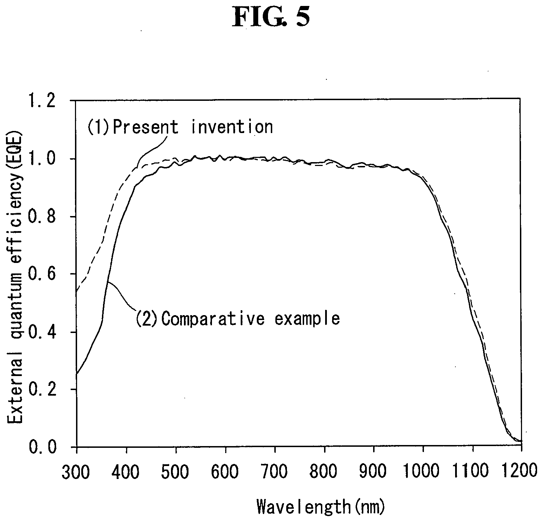

FIG. 5 illustrates an external quantum efficiency of the front surface field region according to the embodiment of the invention.

In FIG. 5, (1) is the embodiment of the invention showing an external quantum efficiency of a microcrystalline silicon (mc-SiCx) layer obtained by crystallizing amorphous silicon (a-SiCx) containing carbon (C); and (2) is a comparative example showing an external quantum efficiency of a microcrystalline silicon (mc-Si:H) layer obtained by crystallizing amorphous silicon (a-Si:H) containing hydrogen (H).

As the external quantum efficiency shown in FIG. 5 increases, a light response may be improved. Further, an electron conversion efficiency with respect to incident light may be improved.

Consequently, as the external quantum efficiency increases, the efficiency of the solar cell may be improved.

As shown in FIG. 5, the embodiment of the invention (1) and the comparative example (2) had a similar level of the external quantum efficiency at a wavelength band equal to or greater than about 500 nm or 600 nm. On the other hand, the external quantum efficiency of the embodiment of the invention (1) was better than the external quantum efficiency of the comparative example (2) at a wavelength band equal to or less than about 500 nm or 600 nm. As the wavelength moved from about 500 nm or 600 nm to 300 nm (i.e., to a short wavelength band), a difference between the external quantum efficiencies of the embodiment of the invention (1) and the comparative example (2) increased.

Because the front surface field region 171 according to the embodiment of the invention includes the polycrystalline silicon material containing at least one of nitrogen (N), carbon (C), and oxygen (O) as described above, the efficiency of the solar cell at the middle or short wavelength band may be further improved.

An example of a method for manufacturing the solar cell according to the embodiment of the invention is described below with reference to FIG. 6.

FIG. 6 is a flow chart showing a method for manufacturing the solar cell according to the embodiment of the invention.

As shown in FIG. 6, a method for manufacturing the solar cell according to the embodiment of the invention may include a front tunnel layer forming operation S1, a doped amorphous silicon layer depositing operation S2, a diffusion barrier layer forming operation S3, a back tunnel layer forming operation S4, a back semiconductor layer forming operation S5, a thermal processing operation S6, a diffusion barrier layer removing operation S7, and an operation S8 of forming an anti-reflection layer and first and second electrodes.

FIG. 6 shows that an operation of forming the anti-reflection layer 130 is included in the front tunnel layer forming operation S1, the back tunnel layer forming operation S4, and the operation S8, as an example. Alternatively, the operation of forming the anti-reflection layer 130 may be omitted.

Further, FIG. 6 shows that the back semiconductor layer forming operation S5 is performed after the diffusion barrier layer forming operation S3, as an example. Alternatively, the back semiconductor layer forming operation S5 may be performed before the front tunnel layer forming operation S1 or before or after the doped amorphous silicon layer depositing operation S2.

As shown in FIG. 6, the front tunnel layer forming operation S1 may be performed before the deposition operation. In the front tunnel layer forming operation S1, a dielectric material containing at least one of silicon carbide (SiCx) and silicon oxide (SiOx) may be deposited on the front surface of the semiconductor substrate 110 containing impurities of the first conductive type to form the front tunnel layer 181.

For example, in the front tunnel layer forming operation S1, a silicon oxide (SiOx) layer may be directly formed on the front surface of the semiconductor substrate 110 through a thermal oxidation method. Methods other than the thermal oxidation method may be used for the front tunnel layer 181.

The front tunnel layer 181 may have a thickness of 0.5 nm to 5 nm. Preferably, but not necessarily, the thickness of the front tunnel layer 181 may be 0.5 nm and 1.6 nm.

The front tunnel layer 181 may prevent impurities of the first conductive type or at least one of nitrogen (N), carbon (C), and oxygen (O) contained in a doped amorphous silicon layer, which will be described later, from being diffused into the semiconductor substrate 110.

Next, in the doped amorphous silicon layer depositing operation S2, the doped amorphous silicon layer may be deposited on the front surface of the semiconductor substrate 110 while injecting impurities of the first conductive type into a chamber.

Thus, when the front tunnel layer 181 is deposited on the front surface of the semiconductor substrate 110, the doped amorphous silicon layer may be deposited on the front surface of the front tunnel layer 181.

The doped amorphous silicon layer depositing operation S2 may be performed using, for example, a plasma enhanced chemical vapor deposition (PECVD) method. Other methods may be used.

When the doped amorphous silicon layer is deposited as described above, at least one of nitrogen (N), carbon (C), and oxygen (O) may be injected (or further injected) into the chamber.

Hence, the doped amorphous silicon layer containing (or further containing) at least one of nitrogen (N), carbon (C), and oxygen (O) may be formed on the front surface of the front tunnel layer 181 in the form of a single layer or a plurality of layers.

The doped amorphous silicon layer containing at least one of nitrogen (N), carbon (C), and oxygen (O) may be deposited at a thickness of 5 nm to 20 nm.

Because the doped amorphous silicon layer depositing operation S2 deposits the doped amorphous silicon layer while injecting impurities of the first conductive type, an addition doping process, which makes the doped amorphous silicon layer have the characteristics of the front surface field region 171, for example, a POCl₃ diffusion process is not necessary. Therefore, the manufacturing method of the solar cell may be further simplified.

Next, in the diffusion barrier layer forming operation S3, a diffusion barrier layer including a dielectric material may be formed on a front surface of the doped amorphous silicon layer. The diffusion barrier layer may be formed using, for example, SiOx or SiCx.

The diffusion barrier layer may prevent impurities of the first conductive type and/or at least one of nitrogen (N), carbon (C), and oxygen (O) contained in the doped amorphous silicon layer from being emitted from the front surface of the doped amorphous silicon layer in the subsequent thermal processing operation S6.

Next, the back tunnel layer forming operation S4 of forming the back tunnel layer 180 including a dielectric material on the back surface of the semiconductor substrate 110 may be performed.

The back tunnel layer forming operation S4 may form a dielectric material containing at least one of SiOx and SiCx on the back surface of the semiconductor substrate 110.

For example, in the back tunnel layer forming operation S4, a silicon oxide (SiOx) layer may be directly formed on the back surface of the semiconductor substrate 110 through the thermal oxidation method. Methods other than the thermal oxidation method may be used for the back tunnel layer 180.

Next, the back semiconductor layer forming operation S5 may be performed. In the back semiconductor layer forming operation S5, an emitter semiconductor layer of the second conductive type opposite the first conductive type and a back surface field semiconductor layer, which contains impurities of the first conductive type at a higher concentration than the semiconductor substrate 110, may be formed on the back surface of the semiconductor substrate 110.

Thus, when the back tunnel layer 180 is formed, the emitter semiconductor layer and the back surface field semiconductor layer may be formed on the back surface of the back tunnel layer 180 in the back semiconductor layer forming operation S5.

In the embodiment disclosed herein, the back surface field semiconductor layer and the emitter semiconductor layer may be formed of an intrinsic polycrystalline silicon layer or an intrinsic amorphous silicon layer containing impurities of the first and second conductive types. A polycrystalline silicon layer may be formed by depositing the intrinsic polycrystalline silicon layer on the back surface of the back tunnel layer 180. Alternatively, the polycrystalline silicon layer may be formed by depositing the intrinsic amorphous silicon layer on the back surface of the back tunnel layer 180.

In order to inject impurities of the first and second conductive types into the back semiconductor layer, a method for diffusing the impurities of the first and second conductive types into the back semiconductor layer in a process for depositing the polycrystalline silicon layer may be used. Alternatively, a method for applying a dopant layer on a back surface of the back semiconductor layer and then injecting the impurities into each of the back surface field semiconductor layer and the emitter semiconductor layer using a laser or through the thermal processing operation S6 may be used.

Next, the thermal processing operation S6 of simultaneously forming the front surface field region 171, the emitter regions 121, and the back surface field regions 172 may be performed.

The thermal processing operation S6 may thermally process the semiconductor substrate 110 and activate impurities of the first and second conductive types to form the emitter region 121 and the back surface field region 172 using the emitter semiconductor layer and the back surface field semiconductor layer, and at the same time, to form the front surface field region 171 using the doped amorphous silicon layer formed on the front surface of the semiconductor substrate 110.

More specifically, at least a portion of the doped amorphous silicon layer containing impurities of the first conductive type and at least one of nitrogen (N), carbon (C), and oxygen (O) on the front surface of the semiconductor substrate 110 may be crystallized into a polycrystalline silicon material through the thermal processing operation S6 to perform a phase change. Further, impurities of the first conductive type may be activated through the thermal processing operation S6.

Hence, the doped amorphous silicon layer formed on the front surface of the semiconductor substrate 110 may be formed as the front surface field region 171 including the polycrystalline silicon material.

Further, impurities of the first and second conductive types injected into the back semiconductor layer may be activated through the thermal processing operation S6.

For example, when the back semiconductor layer for forming the back surface field region 172 and the emitter region 121 is deposited as the polycrystalline silicon layer, impurities of the first and second conductive types may be diffused throughout the polycrystalline silicon layer and activated in the thermal processing operation S6.

Alternatively, when the back semiconductor layer is formed using the intrinsic amorphous silicon layer and impurities of the first and second conductive types are applied to the back surface of the intrinsic amorphous silicon layer, the intrinsic amorphous silicon layer may be recrystallized into the intrinsic polycrystalline silicon layer through the thermal processing operation S6. Further, the impurities of the first and second conductive types may be diffused into the recrystallized intrinsic polycrystalline silicon layer and activated through the thermal processing operation S6. Hence, the back surface field region 172 and the emitter region 121 may be formed.

The thermal processing operation S6 may be performed at a temperature of 800 °C to 925 °C.

Next, the diffusion barrier layer removing operation S7 may be performed. In the diffusion barrier layer removing operation S7, the diffusion barrier layer, which has been formed in the diffusion barrier layer forming operation S3 following the doped amorphous silicon layer depositing operation S2, may be removed.

The diffusion barrier layer may be removed using an etchant including potassium hydroxide (KOH) and hydrogen peroxide (H₂O₂), for example.

Next, the operation S8 of forming the anti-reflection layer and the first and second electrodes is performed. Hence, the anti-reflection layer 130 including a dielectric material may be formed on the exposed front surface of the front surface field region 171, on which the diffusion barrier layer is removed, and the first electrode 141 connected to the emitter region 121 and the second electrode 142 connected to the back surface field region 172 may be formed.

Hence, the solar cell shown in FIGS. 1 to 3 may be manufactured.

As described above, the method for manufacturing the solar cell according to the embodiment of the invention can simultaneously form the front surface field region 171, the back surface field regions 172, and the emitter regions 121 by performing the thermal processing operation S6 once, thereby further simplifying the manufacturing process of the solar cell.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A solar cell comprising:
a semiconductor substrate (110) containing impurities of a first conductive type;
a front surface field region (171) positioned at a front surface of the semiconductor substrate, the front surface field region containing impurities of the first conductive type at a higher concentration than that of the semiconductor substrate, the front surface field region having a crystal structure or crystallinity different from that of the semiconductor substrate;
a front tunnel layer (181) positioned between the front surface field region (171) and the semiconductor substrate (110),
an anti-reflection layer (130) positioned on a front surface of the front surface field region (171),
an emitter region (121) positioned at a back surface of the semiconductor substrate, the emitter region having a second conductive type opposite the first conductive type;
a back surface field region (172) positioned at the back surface of the semiconductor substrate, the back surface field region containing impurities of the first conductive type at a higher concentration than that of the semiconductor substrate;
a first electrode (141) connected to the emitter region; and
a second electrode (142) connected to the back surface field region,
**characterized in that**
the crystallinity of the front surface field region (171) increases from the front tunnel layer (181) to the anti-reflection layer (130).

2. The solar cell of claim 1, wherein the front surface field region (171) contains at least one of nitrogen (N), carbon (C), and oxygen (O).

3. The solar cell of claim 1 or 2, wherein the front surface field region (171) includes a polycrystalline silicon material,
wherein the back surface field region (172) partially includes amorphous silicon, and
wherein the crystallinity of the front surface field region (171) is between 60 % and 100 %.

4. The solar cell of any one preceding claim, wherein a thickness of the front surface field region (171) is 5 nm to 20 nm.

5. The solar cell of any one preceding claim, wherein the front tunnel layer includes a dielectric material,
wherein the dielectric material of the front tunnel layer includes at least one of silicon carbide (SiCx) and silicon oxide (SiOx),
wherein a thickness of the front surface field region is greater than a thickness of the front tunnel layer, and
wherein a thickness of the front tunnel layer is 0.5 nm to 5 nm.

6. The solar cell of any one preceding claim, wherein the anti-reflection layer includes a dielectric material.

7. The solar cell of any one preceding claim, wherein at least one of the emitter region (121) and the back surface field region (172) has a crystal structure different from that of the semiconductor substrate.

8. The solar cell of any one preceding claim, further comprising a back tunnel layer (180) positioned between the back surface of the semiconductor substrate and a front surface of the emitter region, between the back surface of the semiconductor substrate and a front surface of the back surface field region, or both, the back tunnel layer including a dielectric material.

9. A method for manufacturing a solar cell according to any of claims 1 to 8, the method comprising:
a doped amorphous silicon layer depositing operation of depositing a doped amorphous silicon layer on a front surface of a semiconductor substrate while injecting impurities of a first conductive type into a chamber;
a back semiconductor layer forming operation of forming an emitter semiconductor layer of a second conductive type opposite the first conductive type and a back surface field semiconductor layer, which contains impurities of the first conductive type at a higher concentration than that of the semiconductor substrate, on a back surface of the semiconductor substrate; and
a thermal processing operation of thermally processing the semiconductor substrate and recrystallizing the doped amorphous silicon layer to form a front surface field region.

10. The method of claim 9, wherein in the doped amorphous silicon layer depositing operation, at least one of nitrogen (N), carbon (C), and oxygen (O) is injected into the chamber.

11. The method of claim 9 or 10, further comprising:
a diffusion barrier layer forming operation of forming a diffusion barrier layer including a dielectric material on a front surface of the doped amorphous silicon layer between the doped amorphous silicon layer depositing operation and the thermal processing operation; and
an operation of removing the diffusion barrier layer after the thermal processing operation.

12. The method of any one of claims 9 to 11, wherein the thermal processing operation includes activating impurities of the first and second conductive types while forming the front surface field region to form an emitter region and a back surface field region using the emitter semiconductor layer and the back surface field semiconductor layer, respectively.

13. The method of any one of claims 9 to 12, wherein the thermal processing operation includes recrystallizing at least a portion of the doped amorphous silicon layer into a polycrystalline silicon material to perform a phase change.

14. The method of any one of claims 9 to 13, further comprising, before the doped amorphous silicon layer depositing operation, forming a front tunnel layer including a dielectric material on the front surface of the semiconductor substrate,
wherein in the doped amorphous silicon layer depositing operation, the doped amorphous silicon layer is deposited on a front surface of the front tunnel layer.

15. The method of any one of claims 9 to 14, further comprising, before the back semiconductor layer forming operation, forming a back tunnel layer including a dielectric material on the back surface of the semiconductor substrate,
wherein the emitter semiconductor layer and the back surface field semiconductor layer are deposited on a back surface of the back tunnel layer.

## Patentansprüche

1. Solarzelle umfassend:
ein Halbleitersubstrat (110), das Störstellen eines ersten Leitfähigkeitstyps enthält, einen Vorderseitenfeldbereich (171), der an einer Vorderseite des Halbleitersubstrats positioniert ist, wobei der Vorderseitenfeldbereich Störstellen des ersten Leitfähigkeitstyps in einer höheren Konzentration als die des Halbleitersubstrats enthält, wobei der Vorderseitenfeldbereich eine Kristallstruktur oder Kristallinität aufweist, die sich von der des Halbleitersubstrats unterscheidet,
eine vordere Tunnelschicht (181), die zwischen dem Vorderseitenfeldbereich (171) und dem Halbleitersubstrat (110) positioniert ist,
eine Antireflexionsschicht (130), die auf einer Vorderseite des Vorderseitenfeldbereichs (171) positioniert ist,
einen Emitterbereich (121), der an einer Rückseite des Halbleitersubstrats positioniert ist, wobei der Emitterbereich einen dem ersten Leitfähigkeitstyp entgegengesetzten zweiten Leitfähigkeitstyp aufweist,
einen Rückseitenfeldbereich (172), der an der Rückseite des Halbleitersubstrats positioniert ist, wobei der Rückseitenfeldbereich Störstellen des ersten Leitfähigkeitstyps in einer höheren Konzentration als die des Halbleitersubstrats enthält,
eine erste Elektrode (141), die mit dem Emitterbereich verbunden ist, und
eine zweite Elektrode (142), die mit dem Rückseitenfeldbereich verbunden ist,
**dadurch gekennzeichnet, dass**
die Kristallinität des Vorderseitenfeldbereichs (171) von der vorderen Tunnelschicht (181) zur Antireflexionsschicht (130) zunimmt.

2. Solarzelle nach Anspruch 1, wobei der Vorderseitenfeldbereich (171) mindestens einen von Stickstoff (N), Kohlenstoff (C) und Sauerstoff (O) enthält.

3. Solarzelle nach Anspruch 1 oder 2, wobei der Vorderseitenfeldbereich (171) ein polykristallines Siliciummaterial enthält,
wobei der Rückseitenfeldbereich (172) teilweise amorphes Silicium enthält und
wobei die Kristallinität des Vorderseitenfeldbereichs (171) zwischen 60% und 100% liegt.

4. Solarzelle nach einem der vorhergehenden Ansprüche, wobei eine Dicke des Vorderseitenfeldbereichs (171) 5 nm bis 20 nm beträgt.

5. Solarzelle nach einem der vorhergehenden Ansprüche, wobei die vordere Tunnelschicht ein dielektrisches Material enthält,
wobei das dielektrische Material der vorderen Tunnelschicht mindestens eines von Siliciumcarbid (SiCx) und Siliciumoxid (SiOx) enthält,
wobei eine Dicke des Vorderseitenfeldbereichs größer ist als eine Dicke der vorderen Tunnelschicht und
wobei eine Dicke der vorderen Tunnelschicht 0,5 nm bis 5 nm beträgt.

6. Solarzelle nach einem der vorhergehenden Ansprüche, wobei die Antireflexionsschicht ein dielektrisches Material enthält.

7. Solarzelle nach einem der vorhergehenden Ansprüche, wobei mindestens einer des Emitterbereichs (121) und des Rückseitenfeldbereichs (172) eine Kristallstruktur aufweist, die sich von der des Halbleitersubstrats unterscheidet.

8. Solarzelle nach einem der vorhergehenden Ansprüche, ferner umfassend eine hintere Tunnelschicht (180), die zwischen der Rückseite des Halbleitersubstrats und einer Vorderseite des Emitterbereichs, zwischen der Rückseite des Halbleitersubstrats und einer Vorderseite des Rückseitenfeldbereichs oder beides positioniert ist, wobei die hintere Tunnelschicht ein dielektrisches Material enthält.

9. Verfahren zur Herstellung einer Solarzelle nach einem der Ansprüche 1 bis 8, wobei das Verfahren umfasst:
ein Abscheidungsvorgang für eine dotierte amorphe Siliciumschicht zum Abscheiden einer dotierten amorphen Siliciumschicht auf einer Vorderseite eines Halbleitersubstrats, während Störstellen eines ersten Leitfähigkeitstyps in eine Kammer injiziert werden,
ein Bildungsvorgang für eine hintere Halbleiterschicht zum Bilden einer Emitterhalbleiterschicht eines dem ersten Leitfähigkeitstyp entgegengesetzten zweiten Leitfähigkeitstyps und einer Rückseitenfeldhalbleiterschicht, die Störstellen des ersten Leitfähigkeitstyps in einer höheren Konzentration als die des Halbleitersubstrats enthält, auf einer Rückseite des Halbleitersubstrats, und
ein thermischer Verarbeitungsvorgang zum thermischen Verarbeiten des Halbleitersubstrats und zum Rekristallisieren der dotierten amorphen Siliciumschicht, um einen Vorderseitenfeldbereich zu bilden.

10. Verfahren nach Anspruch 9, wobei bei dem Abscheidungsvorgang für eine dotierte amorphe Siliciumschicht mindestens einer von Stickstoff (N), Kohlenstoff (C) und Sauerstoff (O) in die Kammer injiziert wird.

11. Verfahren nach Anspruch 9 oder 10, ferner umfassend:
einen Diffusionssperrschichtbildungsvorgang zum Bilden einer Diffusionssperrschicht mit einem dielektrischen Material auf einer Vorderseite der dotierten amorphen Siliciumschicht zwischen dem Dotierungsvorgang für eine dotierte amorphe Siliciumschicht und dem thermischen Verarbeitungsvorgang, und
einen Vorgang zum Entfernen der Diffusionssperrschicht nach dem thermischen Verarbeitungsvorgang.

12. Verfahren nach einem der Ansprüche 9 bis 11, wobei der thermische Verarbeitungsvorgang ein Aktivieren von Störstellen des ersten und des zweiten Leitfähigkeitstyps umfasst, während der Vorderseitenfeldbereich gebildet wird, um einen Emitterbereich und einen Rückseitenfeldbereich unter Verwendung der Emitterhalbleiterschicht bzw. der Rückseitenfeldhalbleiterschicht zu bilden.

13. Verfahren nach einem der Ansprüche 9 bis 12, wobei der thermische Verarbeitungsvorgang ein Rekristallisieren mindestens eines Teils der dotierten amorphen Siliciumschicht in ein polykristallines Siliciummaterial umfasst, um einen Phasenübergang durchzuführen.

14. Verfahren nach einem der Ansprüche 9 bis 13, ferner umfassend ein Bilden einer vorderen Tunnelschicht mit einem dielektrischen Material auf der Vorderseite des Halbleitersubstrats vor dem Abscheidungsvorgang für eine dotierte amorphe Siliciumschicht,
wobei bei dem Abscheidungsvorgang für eine dotierte amorphe Siliciumschicht die dotierte amorphe Siliciumschicht auf einer Vorderseite der vorderen Tunnelschicht abgeschieden wird.

15. Verfahren nach einem der Ansprüche 9 bis 14, ferner umfassend ein Bilden einer hinteren Tunnelschicht mit einem dielektrischen Material auf der Rückseite des Halbleitersubstrats vor dem Bildungsvorgang der hinteren Halbleiterschicht,
wobei die Emitterhalbleiterschicht und die Rückseitenfeldhalbleiterschicht auf einer Rückseite der hinteren Tunnelschicht abgeschieden werden.

## Revendications

1. Cellule solaire photovoltaïque comprenant :
un substrat semi-conducteur (110) contenant des impuretés d'un premier type conducteur ;
une région de champ de surface avant (171) positionnée sur une face avant du substrat semi-conducteur, la région de champ de surface avant contenant des impuretés du premier type conducteur à une concentration supérieure à celle du substrat semi-conducteur, la région de champ de surface avant ayant une structure en cristal ou une cristallinité différente de celle du substrat semi-conducteur ;
une couche tunnel avant (181) positionnée entre la région de champ de surface avant (171) et le substrat semi-conducteur (110),
une couche antireflet (130) positionnée sur une face avant de la région de champ de surface avant (171),
une région émettrice (121) positionnée sur une face arrière du substrat semi-conducteur, la région émettrice ayant un second type conducteur opposé au premier type conducteur ;
une région de champ de surface arrière (172) positionnée sur la face arrière du substrat semi-conducteur ; la région de champ de surface arrière contenant des impuretés du premier type conducteur à une concentration supérieure à celle de la région émettrice ; et
une première électrode (141) connectée à la région émettrice ; et
une seconde électrode (1'2) connectée à la région de champ de surface arrière,
**caractérisée en ce que**
la cristallinité de la région de champ de surface avant (171) augmente à partir de la couche tunnel avant (181) jusqu'à la couche antireflet (130).

2. Cellule solaire photovoltaïque selon la revendication 1, la région de champ de surface avant (171) contenant au moins de l'azote (N) ; du carbone (C) et de l'oxygène (O).

3. Cellule solaire photovoltaïque selon la revendication 1 ou la revendication 2, la région de champ de surface avant (171) comprenant un matériau en silicium polycristallin,
la région de champ de surface arrière (172) comprenant partiellement du silicium amorphe,
et
la cristallinité de la région de champ de surface avant (171) étant comprise entre 60 % et 100 %.

4. Cellule solaire photovoltaïque selon l'une quelconque des revendications précédentes, une épaisseur de la région de champ de surface avant (171) étant comprise entre 5 nm et 20 nm.

5. Cellule solaire photovoltaïque selon l'une quelconque des revendications précédentes, la couche tunnel avant comprenant un matériau diélectrique,

6. Cellule solaire photovoltaïque selon l'une quelconque des revendications précédentes, la couche antireflet comprenant un matériau diélectrique.

7. Cellule solaire photovoltaïque selon l'une quelconque des revendications précédentes, la région émettrice (121) et/ou la région de champ de surface arrière (172) ayant une structure en cristal différente de celle du substrat semi-conducteur.

8. Cellule solaire photovoltaïque selon une quelconque revendication précédente, comprenant en outre une couche tunnel arrière (180) positionnée entre la face arrière du substrat semi-conducteur et une face avant de la région émettrice, entre la face arrière du substrat semi-conducteur et une face avant de la région de champ de surface arrière, ou les deux, la couche tunnel arrière comprenant un matériau diélectrique.

9. Procédé de fabrication d'une cellule solaire photovoltaïque selon l'une quelconque des revendications 1 à 8, le procédé comprenant :
une opération de dépôt de couche de silicium amorphe dopé consistant à déposer une couche de silicium amorphe dopé sur une face avant d'un substrat semi-conducteur pendant l'injection d'impuretés d'une premier type conducteur dans une chambre ;
une opération de formation de couche arrière semi-conducteur consistant à former une couche émettrice semi-conducteur d'un second type conducteur opposé au premier type conducteur et une couche semi-conductrice de champ de surface arrière qui contient des impuretés du premier type conducteur à une concentration supérieure à celle du substrat semi-conducteur, sur une face arrière du substrat semi-conducteur ; et
une opération de traitement thermique traitant thermiquement le substrat semi-conducteur et permettant de recristalliser la couche de silicium amorphe dopé pour former une région de champ de surface avant.

10. Procédé selon la revendication 9, dans l'opération de dépôt de couche de silicium amorphe dopé, de l'azote (N) et/ou du carbone (C) et/ou de l'oxygène (O) étant injecté dans la chambre.

11. Procédé selon la revendication 9 ou la revendication 10, comprenant en outre :
une opération de formation de couche barrière de diffusion consistant à former une couche barrière de diffusion comprenant un matériau diélectrique sur une face avant de la couche de silicium amorphe dopé entre l'opération de dépôt de couche de silicium amorphe dopé et l'opération de traitement thermique ; et
une opération de retrait de la couche barrière de diffusion après l'opération de traitement thermique.

12. Procédé selon l'une quelconque des revendications 9 à 11, l'opération de traitement thermique consistant à activer les impuretés du premier et du second type conducteur pendant la formation de la région de champ de surface avant pour former une région émettrice et une région de champ de surface arrière à l'aide de la couche semi-conducteur émettrice et la couche de champ de surface arrière respectivement.

13. Procédé selon l'une quelconque des revendications 9 à 12, l'opération de traitement thermique consistant à recristalliser au moins une partie de la couche de silicium amorphe dopé en un matériau de silicium polycristallin pour procéder à un changement de phase.

14. Procédé selon l'une quelconque des revendications 9 à 13, consistant en outre avant l'opération de dépôt de couche de silicium amorphe dopé, à former une couche tunnel avant comprenant un matériau diélectrique sur la face avant du substrat semi-conducteur,
dans l'opération de dépôt de couche de silicium amorphe dopé, la couche de silicium amorphe dopé étant déposée sur une face avant de la couche tunnel avant.

15. Procédé selon l'une quelconque des revendications 9 à 14, consistant en outre à, avant l'opération de formation de couche semi-conducteur arrière, former une couche tunnel arrière comprenant un matériau diélectrique sur la face arrière du substrat semi-conducteur,
la couche émettrice semi-conductrice et la couche semi-conductrice de champ de surface arrière étant déposées sur une face arrière de la couche tunnel arrière.
